# EUROPÄISCHE PATENTSCHRIFT

(11) **EP 0 560 233 B1**
(45) Veröffentlichungstag und Bekanntmachung des Hinweises auf die Patenterteilung: **13.08.1997**
(21) Anmeldenummer: 93103606.5
(22) Anmeldetag: 05.03.1993
(51) Int. Cl.: C04B 37/02, H01L 23/15, F04B 53/00, H01L 23/14, F04B 1/20

(54) **Metall-Keramik-Verbundbauteil**
Metal-ceramic compound component
Pièce composite de métal-céramique

(30) Priorität: 10.03.1992 DE 4207529; 21.03.1992 DE 4209207; 02.04.1992 DE 4210899
(43) Veröffentlichungstag der Anmeldung: 15.09.1993
(73) Patentinhaber: CeramTec AG Innovative Ceramic Engineering, 73207 Plockingen (DE)
(72) Erfinder: Do-Thoi, Tha, W-8505 Röthenbach/P. (DE); Stingl, Peter, Dr., W-8560 Lauf-Kuhnhof (DE); Meier, Gerd, W-8566 Diepersdorf (DE)

(56) Entgegenhaltungen:
- EP-A- 0 111 989
- EP-A- 0 380 200
- EP-A- 0 508 295
- CH-B- 378 765
- US-A- 5 186 380
- CHEMICAL ABSTRACTS, vol. 113, no. 20, 12. November 1990, Columbus, Ohio, US; abstract no. 176609w, K. KASHIWAGI 'Composite braze for joining of ceramics and metals' Seite 268 ; & JP-A-1 249 292 (TANAKA NOBLE METAL INDUSTRIAL CO., LTD.) 4. Oktober 1989
- CHEMICAL ABSTRACTS, vol. 110, no. 10, 6. März 1989, Columbus, Ohio, US; abstract no. 81306u, S. TANAKA ET AL 'Brazed ceramic-metal composite' Seite 375 ; & JP-A-63 215 575 (TOSHIBA CORP.) 8. September 1988
- CHEMICAL ABSTRACTS, vol. 113, no. 20, 12. November 1990, Columbus, Ohio, US; abstract no. 176609w, K. KASHIWAGI 'Composite braze for joining of ceramics and metals' Seite 268 ; & JP-A-1249292
- CHEMICAL ABSTRACTS, vol. 110, no. 10, 6. März 1989, Columbus, Ohio, US; abstract no. 81306u, S. TANAKA ET AL 'Brazed ceramic-metal composite' Seite 375 ; & JP-A-63215575

## Beschreibung

Die vorliegend Erfindung betrifft ein Verbundbauteil, bei dem ein Keramikbauteil mit einem Metallbauteil durch Hartlot verbunden ist, ein Verfahren zu dessen Herstellung und seine Verwendung.

Das Fügen von Keramik und Metall gewinnt zunehmend an Bedeutung, weil es die Voraussetzung für den breiten Einsatz von technischer Keramik als Verbundwerkstoff ist. Seit vielen Jahren hat sich die Anwendung von strukturkeramischen Werkstoffen, insbesondere bei Aluminiumoxiden, in der Elektrotechnik gut bewährt, trotzdem bereitet das Verbinden dieser Werkstoffe bis jetzt immer noch Schwierigkeiten, da das große Mißverhältnis in den elastischen Eigenschaften und insbesondere in der Wärmeausdehnung für die Entstehung von thermischen Eigenspannungen während des Abkühlens verantwortlich ist. Diese Eigenspannungen führen zur Rißbildung im keramischen Teil, weil sich beim Abkühlen von hoher Temperatur nach dem Löten Stahl stärker zusammenzieht als Keramik.

Derzeit gibt es im wesentlichen zwei Techniken zum Verbinden von metallisierter Aluminiumoxidkeramik mit Metallen, bei denen das Keramikteil schonend verbunden wird. Die eine Technik besteht in der ausschließlichen Verwendung von Metallen, die selbst sehr ähnliche Wärmeausdehnungskoeffizienten (WAK) wie Keramik besitzen, beispielsweise von FeNiCo-Legierungen wie ®Vacon oder ®Vacodil, die andere Technik besteht in der Einfügung einer Zwischenschicht aus Metall mit einem WAK und Elastizitätsmodul ähnlich dem des keramischen Materials. Die erste Maßnahme fand bereits vielfach Anwendung in der Elektrotechnik, insbesondere bei der Herstellung von elektronischen Bauteilen, beispielsweise Gehäusen für Überspannungsableiter oder Thyristoren. Diese Werkstoffpaarung ist jedoch aufgrund der hohen Werkstoffkosten für manche Einsatzzwecke nicht unbedingt geeignet. Nach der zweiten Technik wird die zu verbindende Keramikoberfläche metallisiert und in diesem Zustand mit einem Lot, das eine Legierung von Kupfer und Silber enthält, und einem Metallbauteil in einer Lötlehre aus Graphit oder Stahl verbunden. Nachteilig an diesem Verfahren sind die hohen Kosten für das Kupferlot, das jeweils für verschiedene Anwendungen für verschiedene Metalle und verschiedene Keramikzusammensetzungen eigens individuell rezepturiert werden muß, sowie die teilweise sehr aufwendige Positionierung der zu verlötenden Einzelkomponenten, die insbesondere bei Kleinteilen mit äußerster Präzision ausgeführt werden muß und in der Praxis immer wieder zu Beanstandungen führt.

EP-A-0 356 678 lehrt ein Verfahren zum chemischen oder galvanischen Aufbringen eines Lotes auf eine metallisierte Keramik in mindestens zwei Schichten, die beispielsweise aus Kupfer bzw. Silber bestehen können. EP-A-0 508 295 beschreibt ein Verfahren zum chemischen oder galvanischen Aufbringen einer Lotschicht aus mindestens drei Einzelschichten aus Kupfer bzw. Silber mit einer Einzelschichtdicke von 5 bis 10 µm; diese Publikation stammt teilweise von den gleichen Erfindern wie die vorliegende Anmeldung und weist ein Prioritätsdatum 06.04.1991 und ein Veröffentlichungsdatum 14.10.1992 auf.

Es stellte sich damit die Aufgabe, ein geeignetes Mittel zu finden, mit dem die Spannungen zwischen Keramik und Metall vermieden werden und das es ermöglicht, auf einfache Weise einen dauerbeständig haftfesten Verbund zwischen Keramik und Metall zu schaffen, der dauerbeständig extremen Belastungen, beispielsweise im Bereich der Hochleistungselektronik, aber genauso auch den außerordentlichen mechanischen Belastungen beim Betrieb von z.B. Axialkolbenpumpen, ohne Ermüdungserscheinungen gewachsen ist.

Gelöst wird diese Aufgabe durch ein Verbundbauteil nach Anspruch 1, erhalten durch Verlöten eines metallisierten Keramikkörpers mit einer beidseitig versilberten Kupferscheibe als Zwischenschicht und einem Metallkörper, wobei sich unter Lötbedingungen Hartlotlegierungen ausbilden und das Kupfer der Zwischenschicht im Überschuß vorhanden ist.

Das Verfahren zur Herstellung des Verbundbauteils ist in Anspruch 8 beansprucht. Vorteilhafte Ausführungsformen des Produkts sind in den Ansprüchen 2 bis 7 beansprucht, sowie Verwendungen gemäß den Ansprüchen 9 und 10.

Als Keramikkörper sind im Rahmen der vorliegenden Erfindung Körper aus oxidischer und aus nichtoxidischer Keramik geeignet. Als nichtoxidische Keramik kommen vorwiegend Aluminiumnitrid, Siliziumnitrid oder ggf. siliziuminfiltriertes Siliziumkarbid in Frage, während als oxidische Keramik beispielsweise Zirkondioxid, Aluminiumoxid oder Blei-Zirkonat-Titanat geeignet sind, vorzugsweise Al₂O₃-Keramikkörper mit einem Gehalt von mindestens 80, vorzugsweise mindestens 94 % Al₂O₃, die zunächst im Bereich einer Kontaktfläche, vorzugsweise im planaren stirnseitigen Bereich eines zylindrisch geformten Bauteils, metallisiert werden. Die Metallisierung kann erfolgen, indem man zunächst beispielsweise eine Metallisierungspaste auf die Keramik aufbringt und bei einer Temperatur im Bereich von 1200 bis 1500 °C einbrennt. Die Metallisierungspasten enthaften gewöhnlich MnO₂, Al₂O₃ und SiO₂ in wechselnden Zusammensetzungen in Kombination mit einem Metall wie Molybdän oder Wolfram. Damit läßt sich eine dauerbeständig haftfeste Verbindung zwischen Keramikgrundwerkstoff und Metallisierung erreichen. Solche Metallisierungspasten sind beispielsweise beschrieben von Cole et al. in J. am. ceram. Soc., Vol 44, S. 265-271; von Fulrath et al. in Ceramic Bulletin, Vol. 47 (1968), S. 493-497; und von Meyer in Ber. DKG (1965), S. 405-444.

Die Schichtdicke der Metallisierungsschicht beträgt vorteilhafterweise etwa 5 bis 30 µm, vorzugsweise 8 bis 16 µm. Auf die so hergestellte Metallisierung wird dann chemisch oder galvanisch eine zusätzliche Nickelschicht mit einer Dicke von etwa 1 bis 5 µm, vorzugsweise 1,5 bis 2,5 µm, aufgebracht. Die Nickelschicht hilft, die Benetzbarkreit der metallisierten Keramik durch das geschmolzene Lot zu verbessern.

Der auf diese Weise metallisierte Keramikkörper wird in eine Lötlehre aus Graphit oder Stahl gelegt, auf die metallisierte Fläche kommt dann eine versilberte Kupferzwischenschicht zu liegen und darauf wird abschließend ein Metallkörper gelegt. Alle drei Teile werden dann, vorteilhafterweise im Vakuum oder unter Schutzgas, wenigstens auf die Schmelztemperatur des Silber/Kupfer Eutetikums (ca. 790 °C) oder auf etwas darüber liegende Temperaturen über eine Zeitdauer von vorzugsweise wenigstens 5 min, besonders bevorzugt wenigstens 15 min, erhitzt. Man erhält so das dauerbeständig haftfest verbundene Verbundbauteil aus Metall und Keramik.

Die als Zwischenschicht dienende Kupferscheibe hat eine Stärke von mindestens 0,1 mm, vorzugsweise von wenigstens 1,5 mm. Die Stärke dieser Scheibe hängt ab von den Spannungen im Verbund Keramik-Metall und somit auch von der Art des jeweils gewählten Metalls, beziehungsweise der Keramik. Allgemein kann man sagen, daß die Zwischenschicht umso dicker sein muß, je größer die Differenz zwischen dem Wärmeausdehnungskoeffizienten des Metallkörpers und dem Wärmeausdehnungskoeffizienten des Keramikkörpers ist. Die äußere Geometrie der Zwischenschicht richtet sich im wesentlichen nach der Geometrie der zu verbindenden Formkörper. Die Zwischenschicht kann je nach Bedarf kreisförmig oder auch ringförmig, dreieckig, viereckig oder generell polygonal ausgebildet sein.

Als Metallkörper kommen Formkörper aus Stahl, vorzugsweise aus legierten und unlegierten Stahlsorten in Frage. Besonders bewährt haben sich beispielsweise Einsatzstähle, Nitrierstähle, nicht-rostende Stähle, oder Bandstahl. Es können jedoch auch Werkstoffe wie Aluminium, Kobalt, Chrom, Kupfer, Nickel, Platin, Titan oder deren Legierungen mit den eben genannten oder anderen Elementen Verwendung finden, vorzugsweise Kupfer-Beryllium- und Kupfer-Zirkon-Legierungen.

Die Dicke der Silberschicht, die beidseitig auf der Kupferzwischenschicht angeordnet ist, beträgt 5 bis 80 µm, vorzugsweise 9 bis 30 µm. Unter Lötbedingungen bilden sich zwischen dem abgeschiedenen Silber und dem Kupfer der Zwischenschicht Hartlotlegierungen aus, insbesondere mit einer Zusammensetzung entsprechend dem Eutektikum, das 72 Gew.-% Silber und 28 Gew.-% Kupfer enthält. Da das Kupfer der Zwischenschicht auf jeden Fall im Überschuß vorhanden ist, steht die Menge an gebildetem Hartlot in direktem Verhältnis zu der Dicke der Silberschicht. Der Auftrag der Silberschicht erfolgt vorzugsweise nach einem galvanischen Verfahren, es kann aber genausogut auch ein chemisches oder andersartiges Auftragsverfahren, wie z.B. chemical oder physical vapor deposition, gewählt werden.

Die erfindungsgemäßen Verbundbauteile zeichnen sich durch eine dauerbeständig hohe Haftfestigkeit der Verbundpartner unter Dauerbelastung sowie durch Vakuumdichtigkeit aus.

Nach einer weiteren Ausführungsform können die mechanischen Eigenschaften des erfindungsgemäß erhaltenen Verbundkörpers noch weiter verbessert werden, indem man an der Kante eines zylindrisch geformten Al₂O₃-Keramikkörpers eine Fase anbringt. Als optimale Fase wurde hierfür vorzugsweise ein Fasenwinkel von 30 ° und eine projizierte Breite von 0,5 mm ermittelt. Dabei wird die Spitze der Spannungskonzentration vom Rand des Keramikkörpers weg zu dem Lot hin verlagert, das bedeutet, daß die Spannungen sich nicht mehr unmittelbar auf die spröde Keramik auswirken, sondern von dem duktilen Lot aufgenommen werden; dadurch wird die Herstellung rißfreier Verbunde ermöglicht.

Durch den erfindungsgemäßen Einbau eines Keramikteils in den Pumpenkolben einer Axialkolbenpumpe erreicht man insgesamt eine höhere Verschleißfestigkeit des Pumpenkolbens im Vergleich zu Vollstahlkolben.

### Ausführungsbeispiel:

Ein zylindrischer Keramikkörper (Gehalt Al₂O₃ 99,7 %) mit einem Durchmesser von 20 mm und einer Länge von 38,5 mm wurde in eine Lötlehre gelegt. Die kreisförmige Stirnfläche des Keramikkörpers war zuvor nach üblichen Verfahren mit Wolfram und mit Nickel metallisiert worden (Schichtdicke Wolfram: 10 µm; Schichtdicke Nickel: 1,8 µm). Auf die metallisierte Stirnfläche wurde eine Kupferscheibe mit einer Dicke von 1,7 mm gelegt, die beidseitig mit einer Schichtdicke von jeweils 12 µm versilbert worden war. Auf die versilberte Kupferscheibe wurde abschließend ein zylindrischer Stahlkörper (Länge 86 mm) gelegt. Die Lötlehre wurde über eine Zeitdauer von 20 Minuten im Vakuum auf 830 °C erhitzt und man erhielt nach Abkühlen einen Al₂O₃-Stahl Pumpenkolben.

Mit einer Zugspannungsmeßvorrichtung wurde der so hergestellte Pumpenkolben geprüft und es wurde eine Zugfestigkeit von 80 N/mm² gemessen.

Anhand der beigefügten Zeichnungen soll nachfolgend die Erfindung für den Fachmann noch näher erläutert werden.

Figur 1 zeigt einen senkrechten Schnitt durch ein Verbundbauteil aus Metall und Keramik in seitlicher Ansicht als Vergleichsbeispiel.

Figur 2 zeigt einen senkrechten Schnitt durch ein erfindungsgemäßes Verbundbauteil aus Metall und Keramik in seitlicher Ansicht.

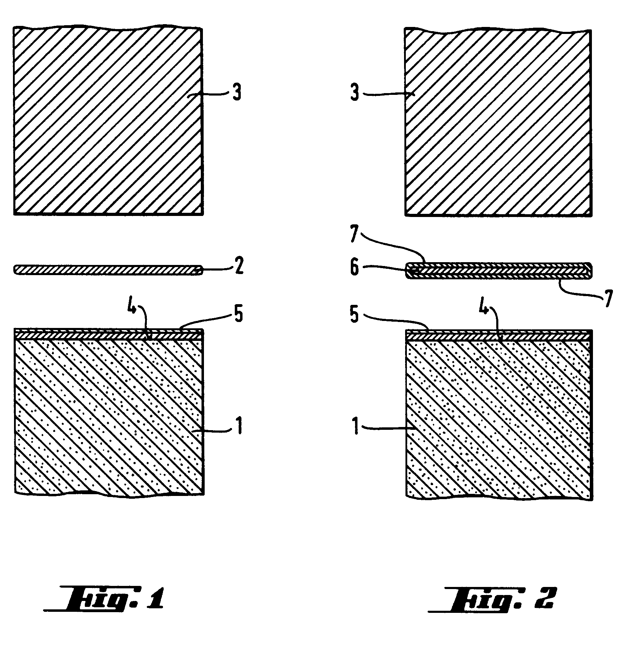

In Figur 1 wird ein Keramischer Werkstoff 1 mit einem metallischen Werkstoff 3 durch Löten verbunden. die für das Lot vorgesehene Fläche 4 ist metallisiert, wofür sich Mo/Mn oder W/TiO₂ eignet. Um die Benetzung für das Lot zu verbessern, wird die metallisierte Fläche 4 galvanisch oder chemisch oder durch andere geeignete Verfahren mit einer Nickelschicht 5 versehen. Die Verbindung des Keramikteils 1 mit dem Metallteil 3 wird durch ein herkömmliches Hartlot 2 aus einer Legierung aus Kupfer und Silber bewirkt, insbesondere durch ein Kupfer-Silber-Eutektikum. Alle Teile 1,2 und 3 werden bei einer Temperatur von 830 °C über eine Zeitdauer von 20 min in einem Vakuumofen oder unter Schutzgasatmosphäre miteinander verlötet.

In der Figur 2 ist das Lot 2 durch eine galvanisch mit Silber 7 beschichtete beschichtete Kupferscheibe 6 ersetzt. Die Kupferscheibe 6 wurde dabei in einem Silberbad auf cyanidischer Basis und einer Konzentration im Bereich von 38 bis 42 g Ag/l bei Raumtemperatur und einer Stromdichte von 0,3 A/dm² über eine Zeitspanne von 120 min behandelt. Dabei entstanden beidseitig Silberschichten 7 von jeweils 16 µm Dicke. Die Lötbedingungen bleiben unverändert. Überraschend zeigt sich, daß die durch die Wärmebehandlung üblicherweise auftretenden mechanischen Spannungen zwischen Metallbauteilen und Keramik mit dem erfindungsgemäßen Verfahren anstandslos ausgeglichen werden. Es ist damit möglich, komplizierte Verbundbauteile aus Metall und Keramik kostengünstiger, ohne aufwendige Präzisionspositionierung und letztlich auch, trotz gleichbleibend hervorragender Qualität, umweltfreundlicher herzustellen.

## Patentansprüche

1. Verbundbauteil, bei dem ein Keramikbauteil mit einem Metallbauteil durch Hartlot verbunden ist, erhalten durch Verlöten eines metallisierten Keramikkörpers mit einer beidseitig versilberten Kupferscheibe als Zwischenschicht und einem Metallkörper, wobei sich unter Lötbedingungen Hartlotlegierungen ausbilden und das Kupfer der Zwischenschicht im Überschuß vorhanden ist.

2. Verbundbauteil nach Anspruch 1, dadurch gekennzeichnet, daß der Metallkörper ein Stahlkörper ist oder im wesentlichen aus Aluminium, Nickel, Chrom, Kobalt, Titan, Kupfer, Palladium oder aus Legierungen der genannten Metalle, vorzugsweise aus Kupfer-Beryllium- und Kupfer-Zirkon-Legierungen, besteht.

3. Verbundbauteil nach Anspruch 1 oder 2, dadurch gekennzeichnet, daß der Keramikkörper aus gesintertem Aluminiumoxid, Zirkonoxid, Aluminiumnitrid, Blei-Zirkonat-Titanat oder Siliziumkarbid besteht.

4. Verbundbauteil nach einem der Ansprüche 1 bis 3, dadurch gekennzeichnet, daß die Metallisierung der Keramik aus Mo, Mo/Mn, W oder W/TiO₂ mit oder ohne Glasfritte aus MnO₂, Al₂O₃ und/oder SiO₂ besteht und eine Schichtdicke im Bereich von 5 bis 30 µm besitzt, vorzugsweise von 8 bis 16 µm und daß auf die Metallisierung eine Nickelschicht mit einer Dicke von etwa 1 bis 5 µm, vorzugsweise 1,5 bis 2,5 µm, aufgebracht ist.

5. Verbundbauteil nach einem der Ansprüche 1 bis 4, dadurch gekennzeichnet, daß die Kupferzwischenschicht eine Schichtdicke von mindestens 0,1 mm besitzt, vorzugsweise von wenigstens 0,9 mm, besonders bevorzugt von wenigstens 1,5 mm, wobei ihre äußere Geometrie kreisförmig, ringförmig, dreieckig, viereckig oder polygonal ist.

6. Verbundbauteil nach einem der Ansprüche 1 bis 5, dadurch gekennzeichnet, daß die Dicke der vorzugsweise galvanisch oder chemisch aufgetragenen Silberschichten, die beidseitig auf der Kupferzwischenschicht angeordnet sind, im Bereich von 5 bis 80 µm liegt, vorzugsweise im Bereich von 9 bis 30 µm.

7. Verbundbauteil nach einem der Ansprüche 1 bis 6, dadurch gekennzeichnet, daß es insgesamt eine zylindrische Form besitzt.

8. Verfahren zum Herstellen eines Verbundbauteils nach einem der Ansprüche 1 bis 7, dadurch gekennzeichnet, daß ein metallisierter Keramikkörper in eine Lötlehre gelegt wird, daß dann auf der metallisierten Fläche eine beidseitig versilberte Kupferscheibe angeordnet wird, daß auf die versilberte Kupferscheibe abschließend ein Metallkörper gelegt wird und daß alle drei Teile dann, vorzugsweise im Vakuum oder unter Schutzgas, über eine Zeitdauer von wenigstens 5 min, vorzugsweise von wenigstens 15 min, auf eine Temperatur von wenigstens 790 °C erhitzt werden, wobei sich unter Lötbedingungen Hartlotlegierungen ausbilden und das Kupfer der Zwischenschicht im Überschuß vorhanden ist.

9. Verwendung eines Verbundbauteils nach einem der Ansprüche 1 bis 7, hergestellt nach Anspruch 8 als Pumpenkolben in Axialkolbenpumpen.

10. Verwendung eines Verbundbauteils nach einem der Ansprüche 1 bis 7, hergestellt nach Anspruch 8 in der Elektrotechnik.

## Claims

1. A composite component, in which a ceramic component is joined to a metal component by a hard solder, obtained by soldering a metallized ceramic body to a copper disk, silver-plated on both sides, as interlayer, and to a metal body, hard solder alloys forming under soldering conditions and the copper of the interlayer being present in excess.

2. The composite component as claimed in claim 1, wherein the metal body is a steel body or is composed essentially of aluminum, nickel, chromium, cobalt, titanium, copper, palladium or of alloys of the said metals, preferably of copper-beryllium and copper-zirconium alloys.

3. The composite component as claimed in claim 1 or 2, wherein the ceramic body consists of sintered aluminum oxide, zirconium oxide, aluminum nitride, lead zirconate titanate or silicon carbide.

4. The composite component as claimed in any of claims 1 to 3, wherein the metallization of the ceramic consists of Mo, Mo/Mn, W or W/TiO₂ with or without glass frit of MnO₂, Al₂O₃ and/or SiO₂ and has a layer thickness in the range from 5 to 30 µm, preferably from 8 to 16 µm, and wherein a nickel layer having a thickness of about 1 to 5 µm, preferably 1.5 to 2.5 µm, has been applied to the metallization.

5. The composite component as claimed in any of claims 1 to 4, wherein the copper interlayer has a layer thickness of at least 0.1 mm, preferably of at least 0.9 mm, particularly preferably of at least 1.5 mm, its outer geometry being circular, annular, triangular, tetragonal or polygonal.

6. The composite component as claimed in any of claims 1 to 5, wherein the thickness of the preferably electrodeposited or chemically deposited silver layers, which are located on both sides of the copper interlayer, is in the range from 5 to 80 µm, preferably in the range from 9 to 30 µm.

7. The composite component as claimed in any of claims 1 to 6, which overall has a cylindrical shape.

8. A process for producing a composite component as claimed in any of claims 1 to 7, which comprises placing a metallized ceramic body into a soldering jig, then arranging a copper disk, silver-plated on both sides, on the metallized surface, finally placing a metal body on the silver-plated copper disk and then heating all three parts, preferably in vacuo or under a blanketing gas, at a temperature of at least 790°C for a period of at least 5 minutes, preferably of at least 15 minutes, hard solder alloys forming under soldering conditions and the copper of the interlayer being present in excess.

9. The use of a composite component as claimed in any of claims 1 to 7, produced as claimed in claim 8, as a pump piston in axial piston pumps.

10. The use of a composite component as claimed in any of claims 1 to 7, produced as claimed in claim 8, in electrotechnology.

## Revendications

1. Elément composite, dans lequel un élément céramique est assemblé à un élément métallique par brasage dur, que l'on obtient par brasage d'un corps céramique métallisé avec un disque de cuivre argenté sur ses deux faces, servant de couche intermédiaire, et un corps métallique, auquel cas, dans les conditions du brasage, il se forme des alliages de brasage dur, et le cuivre de la couche intermédiaire est présent en excès.

2. Elément composite selon la revendication 1, caractérisé en ce que le corps métallique est un corps en acier ou est constitué pour l'essentiel d'aluminium, de nickel, de chrome, de cobalt, de titane, de cuivre, de palladium, ou d'alliages des métaux mentionnés, de préférence d'alliages cuivre-béryllium et cuivre-zirconium.

3. Elément composite selon la revendication 1 ou 2, caractérisé en ce que le corps céramique est constitué d'oxyde d'aluminium, d'oxyde de zirconium, de nitrure d'aluminium, de titanate-zirconate de plomb ou de carbure de sllicium frittés.

4. Elément composite selon l'une des revendications 1 à 3, caractérisé en ce que la métallisation de la céramique est constituée de Mo, Mo/Mn, W ou W/TiO₂, avec ou sans fritte de verre en MnO₂, Al₂O₃ et/ou SiO₂, et présente une épaisseur de couche comprise dans l'intervalle de 5 à 30 µm, de préférence de 8 à 16 µm, et qu'une couche de nickel, ayant une épaisseur d'environ 1 à 5 µm et de préférence de 1,5 à 2,5 µm, est appliquée sur la métallisation.

5. Elément composite selon l'une des revendications 1 à 4, caractérisé en ce que la couche intermédiaire de cuivre a une épaisseur de couche d'au moins 0,1 mm, de préférence d'au moins 0,9 mm et tout particulièrement d'au moins 1,5 mm, sa géométrie extérieure étant circulaire, annulaire, triangulaire, quadrangulaire ou polygonale.

6. Elément composite selon l'une des revendications 1 à 5, caractérisé en ce que l'épaisseur des couches d'argent, appliquées de préférence par voie électrolytique ou chimique, qui sont disposées sur les deux faces sur la couche intermédiaire de cuivre, est comprise entre 5 et 80 µm, de préférence entre 9 et 30 µm.

7. Elément composite selon l'une des revendications 1 à 6, caractérisé en ce qu'il a globalement une forme cylindrique.

8. Procédé de fabrication d'un élément composite selon l'une des revendications 1 à 7, caractérisé en ce qu'on place un corps céramique métallisé dans un gabarit de brasage, que l'on dispose ensuite sur la surface métallisée un disque de cuivre argenté sur ses deux faces, puis que l'on applique sur le disque de cuivre argenté un corps métallique, et que les trois éléments, de préférence sous vide ou sous une atmosphère d'un gaz protecteur, sont ensuite chauffés pendant au moins 5 minutes, de préférence pendant au moins 15 minutes, à une température d'au moins 790°C, auquel cas des alliages de brasage dur se forment dans les conditions du brasage, et le cuivre de la couche intermédiaire est présent en excès.

9. Utilisation d'un élément composite selon l'une des revendications 1 à 7, fabriqué selon la revendication 8 en tant que piston de pompes à piston axial.

10. Utilisation d'un élément composite selon l'une des revendications 1 à 7, fabriqué selon la revendication 8, dans le domaine de l'électrotechnique.
